# EUROPEAN PATENT APPLICATION

(11) **EP 4 220 667 A1**
(43) Date of publication of application: **02.08.2023**
(21) Application number: 22154266.5
(22) Date of filing: 31.01.2022
(51) Int. Cl.: H01B 7/29, H01B 7/14

(54) **POWER CABLE SYSTEM HAVING CABLE SECTIONS WITH DIFFERENT HIGHEST ALLOWED CONDUCTOR TEMPERATURE, AND A METHOD FOR QUALIFYING A POWER CABLE SYSTEM**

(71) Applicant: NKT HV Cables AB, 371 60 Lyckeby (SE)
(72) Inventor: GUSTAFSSON, Kristian, Karlskrona (SE); FRIBERG, Peter, Rödeby (SE); HANSSON, Ola, Karlskrona (SE)
(74) Representative: Kransell & Wennborg KB

(57) **Abstract**

A power cable system (10) comprising at least a first section (12) and a second section (14) is disclosed. The first section (12) is qualified for a first highest allowed conductor temperature and the second section (14) is qualified for a second highest allowed conductor temperature, and the first highest allowed conductor temperature is different than the second highest allowed conductor temperature. A corresponding method (20) is also provided, suitable for individually qualifying the first section (12) and the second section (14) for their respective temperatures according to a set of requirements, such as requirements for testing of high voltage cable systems that is to be installed in a national power grid.

## Description

### Technical field

The technology disclosed herein relates generally to the field of power cable systems, and in particular to a power cable system allowing conductor temperature differences and a method for qualifying a power cable system.

### Background

Power cable systems typically have high current ratings and operate at high loads. Certain cable sections of the power cable system may have a higher conductor temperature than the rest of the cable. These sections are known as hot spots and constitute an important issue to consider when designing an entire power cable system. The hot spots may, for instance, be caused by locally higher thermal resistivity, a nearby external heat source, e.g., steam pipes, or by different burying depths or by other environmental conditions that vary along the length of the power cable system giving different temperature profiles along the power cable system.

A known method for handling such hotspots is to monitor the temperature thereof and provide cooling upon need, or to adjust surrounding conditions with thermal backfill or similar, thereby controlling the potential hotspot. Such measures are expensive and would preferably be avoided. Further, it is not always even possible to implement such temperature control, nor increase cable size and for such cases the existence of hotspots sets the limit for capacity of the power cable system. In particular, if the hotspots cannot be handled, they will limit the capacity of the whole power cable system . There is a need for improvements in this regard.

### Summary

An objective of the present invention is to enable an efficient power cable system design. Another objective is to handle any hotspots in power cable systems, and in particular underground power cable systems, in an improved way.

These objectives, and others, are according to an aspect achieved by a power cable system comprising at least a first section and a second section. The first power cable section is qualified for a first highest allowed conductor temperature, while the second power cable section is qualified for a second highest allowed conductor temperature. The first highest allowed conductor temperature is different than the second highest allowed conductor temperature.

The method provides a number of advantages. By means of the herein disclosed method, the hotspots, which in prior art sets a limitation for the cable design, are handled in an improved and very efficient way. In particular, by allowing cable sections, e.g., sections with a higher burial depth, to have a higher temperature than the rest of the cable system, the different components of the cable system can be run at or close to their respective capacity. This in turn leads to an overall reduction of costs for a cable system, e.g., as the cable size can be reduced. The possible ampacity of the cable system may also be increased if cable sections comprising hot spots are allowed to run at a higher temperature than the rest of the cable system.

In an embodiment, the first section and the second section are qualified according to an acknowledged standard for power cables. In particular embodiments, the first and second sections are qualified according to International Electrotechnical Commission (IEC), Cigre, Association of Edison Illuminating Companies (AEIC) or Insulated Cable Engineers Association (ICEA).

In an embodiment, the first section and the second section are individually qualified for their respective temperatures according to a set of requirements. The set of requirements may, for instance, comprise requirements for testing of high voltage cable systems at a certain conductor temperature, wherein the voltage cable system is to be installed in a national power grid.

In various embodiments, the first highest allowed conductor temperature is lower than the second highest allowed conductor temperature.

In variations of the above set of embodiments, the first highest allowed conductor temperature determines cable size of the power cable system.

In other embodiments, the first section comprises at least one power cable accessory.

In still other embodiments, the second section comprises a power cable section without any power cable accessories.

The objectives are, according to an aspect, achieved by a method for performing a qualification test for qualifying a power cable system for use in a specified type of environment. The method comprises a step of qualifying a first section such as to fulfil a first highest allowed conductor temperature, and a step of qualifying a second section such as to fulfil a second highest allowed conductor temperature, wherein the first highest allowed conductor temperature is different than the second highest allowed conductor temperature. The steps may be performed in any order, simultaneously or essentially simultaneously.

In an embodiment, the qualifying of the first section comprises installing the first section in a first part of the specified environment for a determined period of time and wherein the qualifying of the second section comprises installing the second section in a second part of the specified environment for a determined period of time.

In various embodiments, the method comprises adapting an insulation parameter for the first section and an insulation parameter for the second section such that the first section and the second section obtain the different highest allowed conductor temperatures. This in turn is one way of enabling a successful qualifying.

In an embodiment, the method comprises the steps of individually qualifying the first section and the second section for their respective conductor temperatures according to a set of requirements.

In the above embodiment, the set of requirements may, for instance, comprise requirements for testing of high voltage cable systems that is to be installed in a national power grid.

In various embodiments, the first highest allowed conductor temperature is lower than the second highest allowed conductor temperature, and the method comprises determining the power cable size based on the first highest allowed conductor temperature. When allowing the section without any cable accessories to have a higher highest allowed conductor temperature than the first section, the size of the power cable conductor at the hotspot, and hence the size of the entire conductor, can be reduced. This in turn gives important advantages in cost reductions for the cable and for the cable installation.

Further features and advantages of the present teachings will become clear upon reading the following description and the accompanying drawings.

### Brief description of the drawings

Figure 1 illustrates a prior art power cable system.
Figure 2 illustrates a power cable system and embodiments of the invention.
Figure 3 illustrates an installed exemplary power cable system.
Figure 4 is a flow chart over steps of a method according to an aspect of the invention.

### Detailed description

In the following description, for purposes of explanation and not limitation, specific details are set forth such as particular architectures, interfaces, techniques, etc. in order to provide a thorough understanding. In other instances, detailed descriptions of well-known devices, circuits, and methods are omitted so as not to obscure the description with unnecessary detail. Same reference numerals refer to same or similar elements throughout the description.

A power cable system, for instance an underground power cable system, has to fulfill various requirements. There is, for instance, a prequalification test (PQ test), which qualifies the power cable system as a whole. The PQ test is performed to ensure the reliability of the power cable system for long-term use. The PQ test is typically performed on a power cable system comprising about 100 m of complete power cable and at least one type of each accessory, that is to be part of the prospected power cable system. The cable accessories, e.g., joints and terminations, are hence tested together with the power cable as a complete system for a certain period of time, e.g., for a year, as defined in applicable standards such as the earlier mentioned IEC, Cigre etc. Further, for performing the testing, the power cable system is set-up such as to simulate various laying conditions e.g., direct buried, sub-sea, etc., and is submitted to, inter alia, heating and cooling cycles during e.g., a yearlong testing. The cable system is then examined for approval.

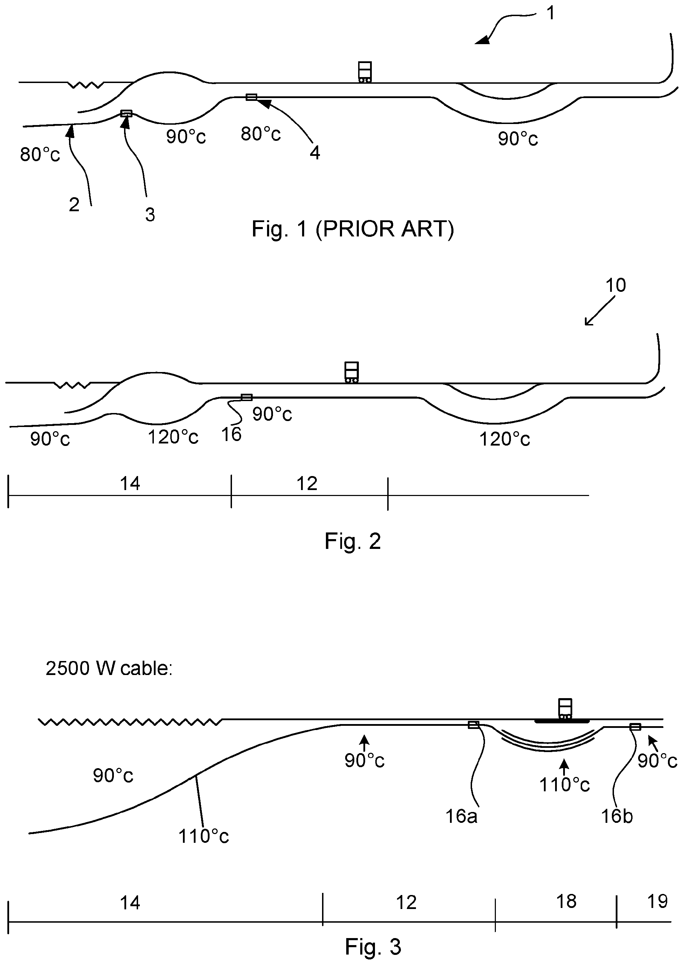

Figure 1 illustrates a conventional power cable system 1 according to prior art, in this case, an underground power cable system. As a typical case example, the power cable system 1 is to be qualified for 90°. This means that all components, i.e., the power cable 2 including its conductor, insulation etc., as well as all other included cable accessories that are part of the power cable system 1, such as e.g., joints 3, cable terminations 4 etc., are qualified to 90°. That is, 90° is the highest allowed conductor temperature for any specific cable section and cable accessory of the power cable system 1. However, there will typically be temperature differences along the underground power cable system 1. As illustrated at left-most side of the figure 1, a sub-sea power cable section 2 and a cable joint 3 might reach only 80° during operation while the part of the power cable section traversing from sub-sea to soil reaches to the highest allowed temperature, 90° during operation. In the figure 1, still another hot spot power cable section is shown at the right-most side of the figure. This hot spot may, for instance, be a section installed via horizontal directional drilling. This means, according to current qualifying testing of power cable systems, that the locations at which the temperature in the power cable system 1 is the highest determine the qualifying temperature. The locations with the highest cable temperature, 90° in this example, therefore, determine the size of the power cable.

Power cables are subjected to comprehensive tests during development, qualification, manufacturing and installation. The various tests serve different purpose with the single overall goal: to ascertain a trouble-free operation under specified conditions during the lifetime of the cable system.

There are various cable system tests, such as, for instance, type tests (e.g., type test on cable and type test on accessories) and Prequalification tests. The standards clearly define how to test a cable in a predefined way to simulate a full lifetime of the cable system. For instance, a High Voltage duration test is made for about 1 month or for over a year in a Prequalification test, wherein the cable is submitted to and experiencing similar "stress ageing" (using shorter time but higher voltage) as it is expected to experience during the total lifetime of the system.

When development tests are done, a full-scale cable of a particular design is manufactured and subjected to the detailed test procedure including the voltages etc. as defined in the standard.

The first test that is part of the technical qualification for commercial use is the Prequalification test (PQ). These PQ tests are also called long-term test, as the load cycles that the cables are subjected to are many and takes more than one year. The purpose of the PQ is to prove that the technology is robust, e.g., in view of the electrical and thermo-mechanical performance of the cable.

These tests validate the cable system design, i.e., all the material that make up a high voltage electrical power line. They are generally performed on a loop including a cable and all the accessories to be used.

The standards define the criteria for judging the relevance of a type test for different cable system, such as cable with a different conductor cross-section but of the same voltage range and with identical accessories. The type tests also serve to qualify the material used to manufacture the cable.

Examples of standards for testing cables comprise:
International standards IEC 60840 for voltages Um≤170 kV and IEC 62067 for higher voltages.
IEC 60840: Power cables with extruded insulation and their accessories for rated voltages above 30 kV (Um = 36 kV) up to 150 kV (Um = 170 kV) - Test methods and requirements
IEC 62067: Power cables with extruded insulation and their accessories for rated voltages above 150 kV (Um = 170 kV) up to 500 kV (Um = 550 kV) - Test methods and requirements

Apart from a type test for a land cable system according to IEC 60840 or IEC 62067, which includes electrical and material testing, a submarine Alternating Current (AC) cable system type test typically includes a more extensive mechanical type test program prior to electrical and material testing. An AC High Voltage (HV) or Extra High Voltage (EHV) submarine cable system may comprise submarine cable(s), termination(s) and different type of joints. The AC submarine cable system, comprising cable(s) and joint(s), has to be mechanically tested to the highest expected mechanical loads during cable installation, laying and repair.

Cigre technical brochure 490 covers a description of mechanical and electrical testing of AC extruded submarine cables intended for use at voltages above 30 (36) kV up to 500 (550) kV:
Cigre TB 490: Recommendations for testing of long AC submarine cables with extruded insulation for system voltage above 30 (36) to 500 (550) kV

The cables manufactured by NKT (DC and AC cables) are currently usually tested in accordance with international standard IEC 62895, Cigre TB 496 and Cigre TB852, but other tests are of course not excluded:
IEC 62895: High voltage direct current (HVDC) power transmission - Cables with extruded insulation and their accessories for rated voltages up to 320 kV for land applications - Test methods and requirements
Cigre TB 496: Recommendations for testing DC extruded cable systems for power transmission at a rated voltage up to 500 kV.
Cigre TB 852: Recommendations for testing DC extruded cable systems for power transmission at rated voltage up to and including 800 kV.

Figure 2 illustrates the same landscape as illustrated in figure 1. In the figure 2, a first power cable section 12 comprises a cable accessory 16, just as in figure 1. However, in this case a second power cable section 14, comprising the sub-sea to soil section, does not comprise any cable accessory at all, since the power cable accommodates the hot spot, as will be described next.

According to an aspect of the invention, the temperature at the hotspot of the second power cable section 14 is allowed to be higher than the temperature at the first power cable section 12. That is, specific cable sections 14 of the power cable system 10 may be qualified for a higher temperature than the rest of the power cable system 10. For instance, the first power cable section 12 maybe qualified for 90°, while the second power cable section 14 is qualified for a higher temperature, e.g., 120°. By means of the feature of allowing differing qualification temperatures, a cable section without cable accessories can be qualified for higher temperatures than the complete underground power cable system 10. This in turn allows for accommodating hot spots of the power cable system, i.e., allowing higher temperatures on thermally critical sections having no cable accessories, e.g., no cable joints. Examples of such hotspots comprise external heat sources, such as steam pipes, different required burying depths where the cable needs to cross obstacles such as cross-roads, rivers or highways, and varying other conditions giving different temperature profiles along the power cable system 10.

By allowing cable sections without cable accessories to be, for instance, 120°, instead of limiting the temperature to be the same as cable sections with accessories, having e.g., 90° as the highest allowed temperature, the size of the power cable can be reduced. This size reduction gives a highly reduced total cost of the underground power cable system while still accommodating hot spots.

A cable system may be technically steered to have different conductor temperatures. For example, the conductor surroundings, e.g., burying depth or surrounding material may be altered, the insulation thickness and/or material or distance between conductor cables may be considered. However, all such actions to keep down the temperature are costly and are therefore preferably avoided. According to the present teachings, such actions may be eliminated by allowing a higher temperature for some cable sections. The power cable system 10 may be divided into different sections and the different sections are allowed to have different temperatures in, e.g., by adapting the conductor size accordingly.

Figure 3 illustrates an exemplary power cable system according to the invention, giving a particular numerical example. In figure 3, a 2500 MW power cable is shown having four different sections: a first section 14, a second section 12, a third section 18 and a fourth section 19. The first section 14 and the third section 18 are sections without any cable accessories and may be qualified for a highest allowed temperature of 110°C. The first section 14 includes a hotspot, created when the power cable traverses from sub-sea to soil and reaches this temperature of 110°C. The second section 12 and the fourth section 19 both comprise a cable accessory 16a, 16b, e.g., cable joints, and may be qualified for a highest allowed temperature of 90°C. The third section 18 is again a section without cable accessories, but has a hotspot reaching 110°C, for instance created by a horizontal directional drilling being required below a highway. The power system 10 may then be qualified to 90°C, while the power cable is qualified for 110°C, giving different highest temperatures on different power cable sections 12, 14, 18, 19.

In the prior art system shown and described with reference to figure 1, the power cable system 1 is qualified for 90°C by sizing the cable conductor such that the conductor temperature will not exceed the allowed 90° at any hotspot. This means that all components, joints as well as other cable accessories and cable sections, are allowed to reach only 90°C. In contrast, as has been described, the invention suggests that the power system 10 maybe qualified to e.g., 90°C, while sections of the power cable having no cable accessories may be qualified for a higher temperature, e.g., 120°C, i.e., be allowed to reach a higher temperature than the sections with cable accessories. By allowing the hotspots to reach a higher temperature, the power cable may then have a smaller size whereby cost reduction is obtained.

The herein described power cable system 10 thus comprises at least a first section 12 and a second section 14. The first section 12 is qualified for a first highest allowed conductor temperature and the second section 14 is qualified for a second highest allowed conductor temperature, and the first highest allowed conductor temperature is different than the second highest allowed conductor temperature.

The first section 12 and the second section 14 (and possibly further sections) are thus qualified for different highest allowed conductor temperatures. In practice this means that the different section may have different temperatures, but the power cable conductor size is the same and the size is based on the first section 12, i.e., the section having at least one accessory. Different cable sections of the power cable system 10 thus have different temperature limitations. The power cable system 10 comprises:
- a power cable having a size that is dimensioned based on a first temperature limit, which in turn is set based on the one or more accessories of the first section 12 of the power cable, and
- a second section 14 of the power cable accommodating a hot spot and having a second temperature limit different than the first temperature limit.

In an embodiment, the first section 12 and the second section 14 are qualified according to an acknowledged standard for power cables. That is, the first and second sections 12, 14 of the power cable both fulfill qualifications of such acknowledged standards. The qualifications may comprise one or more requirements stipulated in the particular standard at hand. Examples of such acknowledged standard comprise IEC Cigre, IEC 62895, Cigre TB 496 etc., as has been described earlier.

In various embodiments, the first section 12 and the second section 14 are individually qualified for their respective highest allowed conductor temperatures according to a set of requirements. Specifically, the first and second sections 12, 14 individually fulfill requirements of a selected acknowledged standard. The set of requirements may, for instance, comprise requirements for testing of high voltage cable systems at a certain conductor temperature, wherein the voltage cable system is to be installed in a power grid.

In various embodiments, the first highest allowed conductor temperature is lower than the second highest allowed conductor temperature.

In various embodiments, the first section 12 comprises at least one power cable accessory and/or the second section 14 comprises a power cable section without any power cable accessories 1.

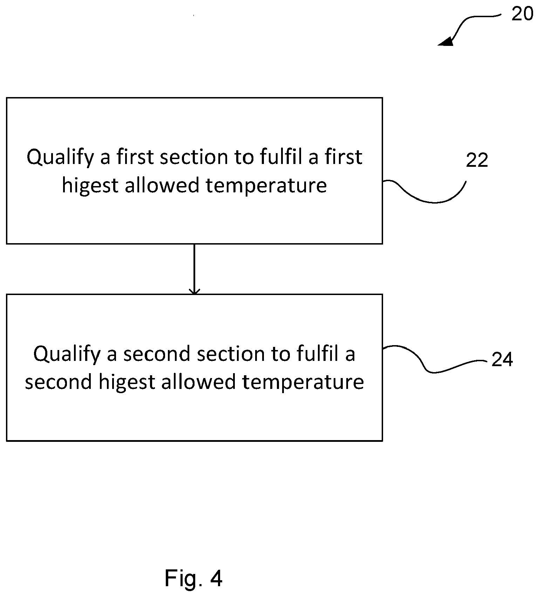

Figure 4 is a flow chart over steps of a method according to an aspect of the invention. The method 20 maybe used for performing qualification test for qualifying a power cable system, such as the power cable system 10 that has been described in various embodiments, and for use in a specified type of environment. The environment in which the power cable system 10 is to be used may comprise sub-sea sections, sub-sea to soil sections, soil sections, etc. The method 20 comprises a step 22 of qualifying a first section 12 so as to fulfil a first highest allowed conductor temperature. The method 20 comprises a step of qualifying a second section 14 so as to fulfil a second highest allowed conductor temperature. The first highest allowed conductor temperature is different than the second highest allowed conductor temperature. It is noted that although the steps are shown in a specific order in the figure, the steps may be performed in any order, simultaneously, or essentially simultaneously.

In an embodiment, the qualifying of the first section 12 comprises installing the first section 12 in a first part of the specified environment for a determined period of time, and the qualifying of the second section 14 comprises installing the second section 14 in a second part of the specified environment for a determined period of time. The determined periods of time may typically (but need not) be the same for the sections 12, 14. The period of time may, for instance, be one year or thereabout.

In various embodiments, the method 20 comprises adapting an insulation parameter (insulation applied outside the cable during testing) for the first section 12 and an insulation parameter for the second section 14 such that the first section 12 and the second section have the different highest allowed conductor temperatures. The insulation parameter may, for instance, comprise the thickness of the insulation, number of insulation layers etc.

In an embodiment, the method 20 comprises steps of individually qualifying the first section 12 and the second section 14 for their respective conductor temperatures according to a set of requirements. The set of requirements may, for instance, comprise requirements for testing of high voltage cable systems that is to be installed in a national power grid.

In various embodiments, the first highest allowed conductor temperature is lower than the second highest allowed conductor temperature, and the method 20 comprises determining the power cable size based on the first highest allowed conductor temperature.

In various embodiments, the method 20 comprises continuously registering, in a measuring device, specified parameters of the power cable system 10.

The conductor temperature of the test cable (i.e., cable under test) can normally not be measured directly due to the high test voltage. Instead, a reference cable with identical design and test conditions is used for measuring the conductor temperature, including thermal insulation, but is not exposed to high voltage.

An enhanced thermal insulation may be used such that the cable circuit under testing can have different conductor temperatures while seeing the same heating current.

By measuring the surface temperature of both the test cable and reference cable with e.g., local sensors or with Distributed Temperature Sensing (DTS) by fiber optics, and assuming that the temperature drops over the insulation is the same, the test cable conductor temperature is determined.

The higher conductor temperature for the second section 14 (higher than for the first section 12) may, for instance, be achieved by having the described enhanced thermal insulation for it. The enhanced thermal insulation creates a higher temperature difference between the conductor and the ambient temperature. Another way to achieve the higher conductor temperature for the second section 14 is to increase the temperature surrounding the cable.

The invention has mainly been described herein with reference to a few embodiments. However, as is appreciated by a person skilled in the art, other embodiments than the particular ones disclosed herein are equally possible within the scope of the invention, as defined by the appended patent claims.

## Claims

1. A power cable system (10) comprising at least a first section (12) and a second section (14), **characterized by** the first section (12) being qualified for a first highest allowed conductor temperature and the second section (14) being qualified for a second highest allowed conductor temperature, wherein the first highest allowed conductor temperature is different than the second highest allowed conductor temperature.

2. The power cable system (10) as claimed in claim 1, the first section (12) and the second section (14) being qualified according to an acknowledged standard for power cables.

3. The power cable system (10) as claimed in claim 1 or 2, wherein each of the first section (12) and the second section (14) fulfills all requirements of an acknowledged standard for power cables.

4. The power cable system (10) as claimed in claim 2 or 3, wherein the acknowledged standard comprises IEC and Cigre documents selected among: IEC 60840: Power cables with extruded insulation and their accessories for rated voltages above 30 kV (Um = 36 kV) up to 150 kV (Um = 170 kV), Test methods and requirements IEC 62067, IEC 62895: High voltage direct current (HVDC) power transmission - Cables with extruded insulation and their accessories for rated voltages up to 320 kV for land applications, Cigre TB 496: Recommendations for testing DC extruded cable systems for power transmission at a rated voltage up to 500 kV and Cigre TB 852: Recommendations for testing DC extruded cable systems for power transmission at a rated voltage up to and including 800 kV, or any applicable future versions.

5. The power cable system (10) as claimed in any of the preceding claims, the first section (12) and the second section (14) being individually qualified for their respective highest allowed conductor temperatures according to a set of requirements.

6. The power cable system (10) as claimed in any of the preceding claims, wherein each of the first section (12) and the second section (14) individually fulfills a set of requirements of an acknowledged standard for power cables.

7. The power cable system (10) as claimed in claim 5 or 6, wherein the set of requirements comprise requirements for testing of high voltage cable systems at a certain conductor temperature, wherein the high voltage cable system is to be installed in a power grid.

8. The power cable system (10) as claimed in claim 5, wherein the power grid is a national power grid.

9. The power cable system (10) as claimed in any of the preceding claims, wherein the first highest allowed conductor temperature is lower than the second highest allowed conductor temperature.

10. The power cable system (10) as claimed in any of the preceding claims, wherein the first section (12) comprises at least one power cable accessory.

11. The power cable system (10) as claimed in any of the preceding claims, wherein the second section (14) comprises a power cable section without any power cable accessories (1).

12. A method (20) for performing a qualification test for qualifying a power cable system (10) for use in a specified type of environment, the method (20) comprising:
- qualifying a first section (12) of the power cable system (10) such as to fulfil a first highest allowed conductor temperature, and
- qualifying a second section (14) of the power cable system (10) such as to fulfil a second highest allowed conductor temperature, wherein the first highest allowed conductor temperature is different than the second highest allowed conductor temperature.

13. The method (20) as claimed in claim 12, wherein the qualifying of the first section (12) comprises installing the first section (12) in a first part of the specified environment for a determined period of time, and wherein the qualifying of the second section (14) comprises installing the second section (14) in a second part of the specified environment for a determined period of time.

14. The method (20) as claimed in claim 12 or 13, comprising adapting an insulation parameter for the first section (12) and an insulation parameter for the second section (14) such that the first section (12) and the second section have the different highest allowed conductor temperatures, enabling a successful qualifying.

15. The method (20) as claimed in any of claims 12 - 14, comprising individually qualifying the first section (12) and the second section (14) for their respective conductor temperatures according to a set of requirements.

16. The method (20) as claimed in claim 15, wherein the set of requirements comprise requirements for testing of high voltage cable systems that is to be installed in a national power grid.

17. The method (20) as claimed in any of claims 12 - 16, wherein the first highest allowed conductor temperature is lower than the second highest allowed conductor temperature, and the method (20) comprises determining the power cable size based on the first highest allowed conductor temperature.

18. The method (20) as claimed in any of claims 12 - 17, comprising continuously registering, in a measuring device, specified parameters of the power cable system (10).
